# EUROPEAN PATENT APPLICATION

(11) **EP 4 622 428 A1**
(43) Date of publication of application: **24.09.2025**
(21) Application number: 25155555.3
(22) Date of filing: 03.02.2025
(51) Int. Cl.: H10K 50/813, H10K 50/816, H10K 59/122, H10K 59/80

(54) **DISPLAY DEVICE AND METHOD OF FABRICATING THE DISPLAY DEVICE**

(30) Priority: 22.03.2024 KR 20240039908
(71) Applicant: Samsung Display Co., Ltd., Yongin-si, Gyeonggi-do 17113 (KR)
(72) Inventor: YANG, Su Kyoung, Yongin-si (KR); PARK, Joon Yong, Yongin-si (KR); LEE, Dong Min, Yongin-si (KR); LEE, Ju Hyun, Yongin-si (KR)
(74) Representative: Marks & Clerk LLP

(57) **Abstract**

A display device includes a pixel electrode including a lower transparent electrode layer disposed on a substrate, a metal electrode layer disposed on the lower transparent electrode layer, and an upper transparent electrode layer disposed on the metal electrode layer; an inorganic pixel defining layer disposed on the substrate and exposing the pixel electrode; a light emitting layer disposed on the pixel electrode; a common electrode disposed on the light emitting layer; a first bank disposed on the inorganic pixel defining layer; and a second bank disposed on the first bank and having a side surface protruding more than a side surface of the first bank. A side surface of the lower transparent electrode layer is aligned with a side surface of the metal electrode layer or protrudes more than the side surface of the metal electrode layer.

## Description

### BACKGROUND

### 1. Technical Field

The present disclosure relates to a display device and a method of fabricating the display device.

### 2. Description of the Related Art

As the information society develops, the demand for display devices for displaying images has increased and diversified. For example, display devices have been applied to various electronic devices such as, for example, smartphones, digital cameras, laptop computers, navigation devices, and smart televisions. The display devices may be flat panel display devices such as, for example, liquid crystal display devices, field emission display devices, or organic light emitting display devices. Among such flat panel display devices, a light emitting display device may display an image without a backlight unit providing light to a display panel because each of the pixels of the display panel includes light emitting elements that may emit light by themselves.

Recently, the display devices have been applied to glasses-type devices for providing virtual reality and augmented reality. The display device is implemented in a very small size of 2 inches or less in order to be applied to the glasses-type device, but should have a high pixel integration degree in order to be implemented with high resolution. For example, the display device may have a high pixel integration degree of 400 pixels per inch (PPI) or more.

When a display device is implemented in the very small size but has the high pixel integration degree as described above, areas of emission areas where light emitting elements are disposed are reduced, and thus, it is difficult to implement light emitting elements separated from each other for each emission area through a mask process.

### SUMMARY

Aspects of the present disclosure provide a method of fabricating a display device, in which the method is capable of forming light emitting elements separated from each other for each emission area without a mask process.

Aspects of the present disclosure also provide a display device robust against moisture permeation.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

Detailed contents of other embodiments are described in a detailed description and are illustrated in the drawings.

In an embodiment of the disclosure, a display device includes a pixel electrode including a lower transparent electrode layer disposed on a substrate, a metal electrode layer disposed on the lower transparent electrode layer, and an upper transparent electrode layer disposed on the metal electrode layer; an inorganic pixel defining layer disposed on the substrate and exposing the pixel electrode; a light emitting layer disposed on the pixel electrode; a common electrode disposed on the light emitting layer; a first bank disposed on the inorganic pixel defining layer; and a second bank disposed on the first bank and having a side surface protruding more than a side surface of the first bank, wherein a side surface of the lower transparent electrode layer is aligned with a side surface of the metal electrode layer or protrudes more than the side surface of the metal electrode layer.

In an embodiment, the side surface of the metal electrode layer may protrude more than a side surface of the upper transparent electrode layer.

In an embodiment, at least a portion of an upper surface of the metal electrode layer, an edge of the metal electrode layer, or the side surface of the metal electrode layer may be exposed and not be covered by the upper transparent electrode layer.

In an embodiment, at least a portion of an upper surface of the lower transparent electrode layer, an edge of the lower transparent electrode layer, or the side surface of the lower transparent electrode layer may be exposed and not be covered by the metal electrode layer.

In an embodiment, the lower transparent electrode layer and the upper transparent electrode layer may respectively include different transparent conductive oxides (TCO).

In an embodiment, the lower transparent electrode layer may include zinc indium tin oxide (ZITO), and the upper transparent electrode layer includes indium tin oxide (ITO).

In an embodiment, the lower transparent electrode layer may be amorphous.

In an embodiment, a ratio of zinc (Zn) to a total number of metal atoms included in the lower transparent electrode layer may be 25 at% to 45 at%, and a ratio of tin (Sn) to a total number of metal atoms included in the lower transparent electrode layer is 15 at% to 35 at%.

In an embodiment, a thickness of the lower transparent electrode layer may be greater than a thickness of the upper transparent electrode layer.

In an embodiment, a thickness of the metal electrode layer may be greater than each of a thickness of the lower transparent electrode layer and a thickness of the upper transparent electrode layer.

In an embodiment, a thickness of the lower transparent electrode layer may be 1 nm to 25 nm.

In an embodiment, the display may further include residual pattern disposed between the upper transparent electrode layer and the inorganic pixel defining layer.

In an embodiment, the residual pattern may include a first side aligned with a side surface of the upper transparent electrode layer.

In an embodiment, the inorganic pixel defining layer may include a first side surface adjacent to the first bank; a first lower surface connected to the first side surface and facing an upper surface of the residual pattern; a second side surface connected to the first lower surface and facing the first side surface of the residual pattern and the side surface of the upper transparent electrode layer; a second lower surface connected to the second side surface and facing an upper surface of the metal electrode layer; and a third side surface connected to the second lower surface and facing the side surface of the metal electrode layer. The first side surface of the inorganic pixel defining layer may protrude more than the second side surface of the inorganic pixel defining layer, and the second side surface of the inorganic pixel defining layer may protrude more than the third side surface of the inorganic pixel defining layer.

In an embodiment, the residual pattern includes a second side surface opposite to the first side surface, and the second side surface of the residual pattern may be aligned with the first side surface of the inorganic pixel defining layer or is positioned between the first side surface of the inorganic pixel defining layer and the second side surface of the inorganic pixel defining layer.

In an embodiment, the inorganic pixel defining layer may further include a third lower surface connected to the third side surface and facing an upper surface of the lower transparent electrode layer and a fourth side surface connected to the third lower surface and facing the side surface of the lower transparent electrode layer.

In an embodiment, one end of the common electrode and another end of the common electrode may be in contact with the first bank.

In an embodiment of the disclosure, a method of fabricating a display device includes forming a lower transparent electrode material layer on a substrate, forming a metal electrode material layer on the lower transparent electrode material layer, forming an upper transparent electrode material layer on the metal electrode material layer, and forming a sacrificial layer on the upper transparent electrode material layer; performing a first etching process of etching the sacrificial layer, the upper transparent electrode material layer, and the metal electrode material layer; and performing a second etching process of etching the lower transparent electrode material layer, wherein the first etching process and the second etching process respectively use different etchants.

In an embodiment, the performing of the second etching process including the etching of the lower transparent electrode material layer may include controlling the second etching process such that a side surface of the lower transparent electrode material layer is aligned with a side surface of the metal electrode material layer or protrudes more than the side surface of the metal electrode material layer.

In an embodiment, the first etching process may use a fluorine-based etchant, and the second etching process may use a phosphoric acid-based, nitric acid-based, or acetic acid-based etchant.

In an embodiment, an electronic device comprises: a display device, the display device comprising: a pixel electrode comprising a lower transparent electrode layer disposed on a substrate, a metal electrode layer disposed on the lower transparent electrode layer, and an upper transparent electrode layer disposed on the metal electrode layer; an inorganic pixel defining layer disposed on the substrate and exposing the pixel electrode;

a light emitting layer disposed on the pixel electrode; a common electrode disposed on the light emitting layer; a first bank disposed on the inorganic pixel defining layer; and a second bank disposed on the first bank and having a side surface protruding more than a side surface of the first bank, wherein a side surface of the lower transparent electrode layer is aligned with a side surface of the metal electrode layer or protrudes more than the side surface of the metal electrode layer.

At least some of the above and other features of the invention are set out in the claims.

A display device according to an embodiment may have a structure preventing light emitting elements from being damaged due to moisture penetration. The respective light emitting elements have uniform luminance, and thus aspects of the display device may prevent mura from occurring in the display device.

The effects of the present disclosure are not limited to the aforementioned effects, and various other effects are included in the present specification.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to an embodiment;
FIG. 2 is a cross-sectional view of the display device of FIG. 1 viewed from the side;
FIG. 3 is a plan view illustrating an arrangement of emission areas in a display area of the display device according to an embodiment;
FIG. 4 is a cross-sectional view illustrating a portion of the display device according to an embodiment;
FIG. 5 is an enlarged view of area A1 of FIG. 4;
FIG. 6 is an enlarged view of area A2 of FIG. 5;
FIG. 7 is an enlarged cross-sectional view illustrating a portion of the display device according to an embodiment; and
FIGS. 8 to 16 are cross-sectional views sequentially illustrating processes for fabrication of the display device according to an embodiment.
FIG. 17 is a block diagram of an electronic device according to one embodiment of the present disclosure.
FIG. 18 is a schematic diagram of an electronic device according to various embodiments of the present disclosure.

### DETAILED DESCRIPTION

The invention now will be described more fully hereinafter with reference to the accompanying drawings, in which various embodiments are illustrated. Aspects supported by the present disclosure may, however, be embodied in many different forms, and should not be construed as limited to the embodiments set forth herein. Rather, the example embodiments are provided such that this disclosure will be thorough and complete, and will fully convey the scope of example aspects of the present disclosure to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third," and the like may be used herein to describe various elements, components, regions, layers and/or sections, these elements, components, regions, layers and/or sections should not be limited by these terms. These terms are used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as, for example, "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The terms "about" and "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of example embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the present disclosure will be described in detail with reference to the accompanying drawings.

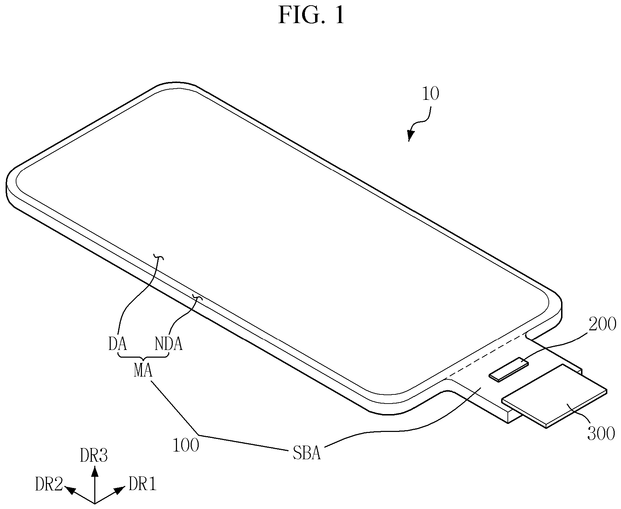

FIG. 1 is a perspective view illustrating a display device according to an embodiment.

Referring to FIG. 1, a display device 10 according to an embodiment may be included in an electronic device and provide a screen displayed on the electronic device. The electronic device may refer to all electronic devices that provide display screens. For example, televisions, laptop computers, monitors, billboards, the Internet of Things (IoT), mobile phones, smartphones, tablet personal computers (PCs), electronic watches, smart glasses, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the electronic device.

A shape of the display device 10 may be variously changed. For example, the display device 10 may have a shape similar to a rectangular shape having short sides in a first direction DR1 and long sides in a second direction DR2. A corner where the short side in the first direction DR1 and the long side in the second direction DR2 meet may be rounded with a curvature, but is not limited thereto, and may also be right-angled. The shape of the display device 10 in a plan view is not limited to the rectangular shape, and may be a shape similar to other polygonal shapes, a circular shape, or an elliptical shape.

The display device 10 may include a display panel 100, a display driver 200, a circuit board 300, and a touch driver 400.

The display panel 100 may include a main area MA and a sub-area SBA.

The main area MA may include a display area DA including pixels displaying an image and a non-display area NDA disposed around the display area DA. The display area DA may emit light from a plurality of emission areas or a plurality of opening areas. For example, the display panel 100 may include pixel circuits including switching elements, an inorganic pixel defining layer defining the emission areas or the opening areas, and self-light emitting elements.

For example, the self-light emitting element may include at least one of an organic light emitting diode (LED) including an organic light emitting layer, a quantum dot LED including a quantum dot light emitting layer, an inorganic LED including an inorganic semiconductor, and a micro LED, but is not limited thereto.

A plurality of pixels, a plurality of scan lines, a plurality of data lines, and a plurality of power lines may be disposed in the display area DA. Each of the plurality of pixels may be defined as a minimum unit emitting light, and each of the self-light emitting elements described herein may be each of the pixels. The plurality of scan lines may supply scan signals received from a scan driver to the plurality of pixels. The plurality of data lines may supply data voltages received from the display driver 200 to the plurality of pixels. The plurality of power lines may supply source voltages received from the display driver 200 to the plurality of pixels.

The non-display area NDA may be an area outside the display area DA. The non-display area NDA may be defined as an edge area of the main area MA of the display panel 100. The non-display area NDA may include the scan driver supplying the scan signals to the scan lines, and fan-out lines connecting the display driver 200 and the display area DA to each other.

The sub-area SBA may be an area extending from one side of the main area MA. The sub-area SBA may include a flexible material that may be bent, folded, and rolled. In an example in which the sub-area SBA is bent, the sub-area SBA may overlap the main area MA in a thickness direction (third direction DR3). The sub-area SBA may include the display driver 200 and pad portions connected to the circuit board 300. In another embodiment, the sub-area SBA may be omitted, and the display driver 200 and the pad portions may be disposed in the non-display area NDA.

The display driver 200 may output signals and voltages for driving the display panel 100. The display driver 200 may supply the data voltages to the data lines. The display driver 200 may supply the source voltages to the power lines and supply scan control signals to the scan driver. The display driver 200 may be formed as an integrated circuit (IC) and mounted on the display panel 100 in a chip on glass (COG) manner, a chip on plastic (COP) manner, or an ultrasonic bonding manner. As an example, the display driver 200 may be disposed in the sub-area SBA, and may overlap the main area MA in the thickness direction (third direction DR3) by bending of the sub-area SBA. As another example, the display driver 200 may be mounted on the circuit board 300.

The circuit board 300 may be attached onto the pad portions of the display panel 100 using an anisotropic conductive film (ACF). Lead lines of the circuit board 300 may be electrically connected to the pad portions of the display panel 100. The circuit board 300 may be a flexible printed circuit board, a printed circuit board, or a flexible film such as, for example, a chip on film.

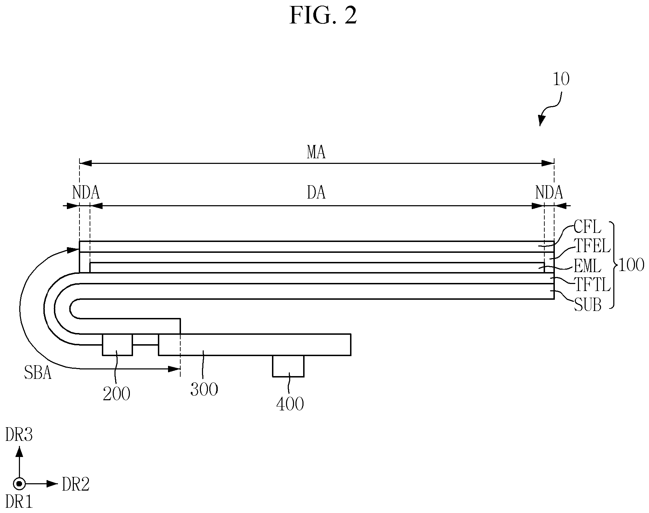

FIG. 2 is a cross-sectional view of the display device of FIG. 1 viewed from the side. Specifically, FIG. 2 illustrates a side surface of the display device of FIG. 1 in a state in which the display device is folded.

Referring to FIG. 2, the display panel 100 may include a substrate SUB, a thin film transistor layer TFTL, a light emitting element layer EML, a thin film encapsulation layer TFEL, and a color filter layer CFL.

The substrate SUB may be a base substrate or a base member. The substrate SUB may be a flexible substrate that may be bent, folded, and rolled. For example, the substrate SUB may include a polymer resin such as, for example, polyimide (PI), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting pixel circuits of pixels. The thin film transistor layer TFTL may further include scan lines, data lines, power lines, scan control lines, fan-out lines connecting the display driver 200 and the data lines to each other, and lead lines connecting the display driver 200 and the pad portions to each other. Each of the thin film transistors may include a semiconductor region, a source electrode, a drain electrode, and a gate electrode. In an example in which the scan driver is formed on one side of the non-display area NDA of the display panel 100, the scan driver may include thin film transistors.

The thin film transistor layer TFTL may be disposed in the display area DA, the non-display area NDA, and the sub-area SBA. The thin film transistors of each of the pixels, the scan lines, the data lines, and the power lines of the thin film transistor layer TFTL may be disposed in the display area DA. The scan control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements each including a first electrode, a second electrode, and a light emitting layer to emit light and an inorganic pixel defining layer defining the pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. In an example in which the first electrode receives a voltage through the thin film transistor of the thin film transistor layer TFTL and the second electrode receives a cathode voltage, holes and electrons may move to the organic light emitting layer through the hole transporting layer and the electron transporting layer, respectively, and may be combined with each other in the organic light emitting layer to emit light.

In another embodiment, the light emitting element may include a quantum dot light emitting diode including a quantum dot light emitting layer, an inorganic light emitting diode including an inorganic semiconductor, or a micro light emitting diode.

The thin film encapsulation layer TFEL may cover an upper surface and side surfaces of the light emitting element layer EML, and may protect the light emitting element layer EML. The thin film encapsulation layer TFEL may include at least one inorganic film and at least one organic film for encapsulating the light emitting element layer EML.

The color filter layer CFL may be disposed on the thin film encapsulation layer TFEL. The color filter layer CFL may include a plurality of color filters respectively corresponding to the plurality of emission areas. Each of the color filters may selectively transmit light of a specific wavelength therethrough and block or absorb light of other wavelengths. The color filter layer CFL may absorb some of light introduced from the outside of the display device 10 to reduce reflected light by external light. Accordingly, the color filter layer CFL may prevent distortion of colors due to external light reflection.

Since the color filter layer CFL is directly disposed on the thin film encapsulation layer TFEL, the display device 10 may be implemented without a separate substrate for the color filter layer CFL. Accordingly, a thickness of the display device 10 may be relatively small.

In some embodiments, the display device 10 may further include an optical device. The optical device may emit or receive light of infrared, ultraviolet, and visible light bands. For example, the optical device may be an optical sensor sensing light incident on the display device 10, such as, for example, a proximity sensor, an illuminance sensor, a camera sensor, a fingerprint sensor, or an image sensor.

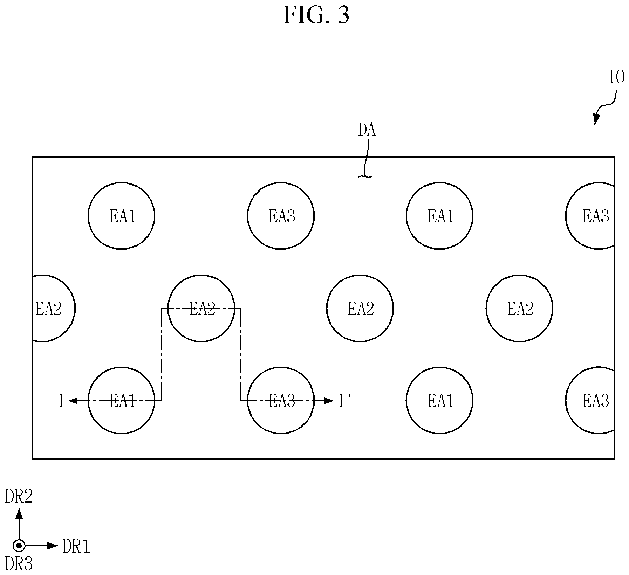

FIG. 3 is a plan view illustrating a portion of the display device according to an embodiment. FIG. 3 is a plan view illustrating an arrangement of emission areas EA1, EA2, and EA3 in the display area DA of the display device 10.

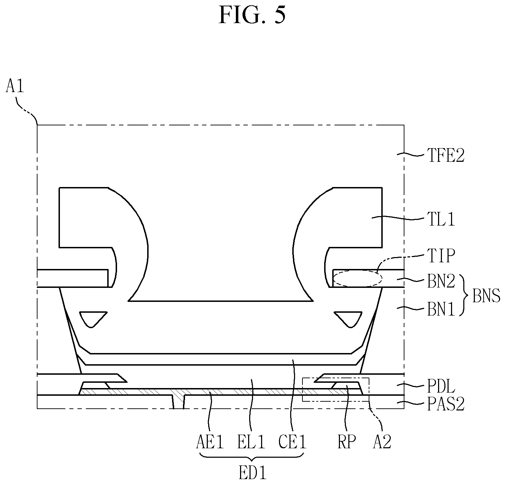

Referring to FIG. 3, the display device 10 may include a plurality of emission areas EA1, EA2, and EA3 disposed in the display area DA. The emission areas EA1, EA2, and EA3 may include first emission areas EA1, second emission areas EA2, and third emission areas EA3 that emit light of different colors. The first to third emission areas EA1, EA2, and EA3 may emit red light, green light, or blue light, respectively, and colors of the light emitted from the respective emission areas EA1, EA2, and EA3 may be different depending on types of light emitting element ED1, ED2, and ED3 (see FIG. 5) to be described later. As an example, the first emission area EA1 may emit first light, which is the red light, the second emission area EA2 may emit second light, which is the green light, and the third emission area EA3 may emit third light, which is the blue light. However, embodiments of the present disclosure are not limited thereto.

The plurality of emission areas EA1, EA2, and EA3 may be disposed in a PenTile^{™} type, for example, a diamond PenTile^{™} type. For example, the first emission areas EA1 and the third emission areas EA3 may be disposed to be spaced apart from each other in the first direction DR1, and may be alternately disposed in the first direction DR1 and the second direction DR2. The second emission areas EA2 may be spaced apart from other adjacent second emission areas EA2 in the first direction DR1 and the second direction DR2. The second emission areas EA2 and the first emission areas EA1 or the second emission areas EA2 and the third emission areas EA3 may be alternately disposed along any one direction on a plane formed by the first direction DR1 and the second direction DR2.

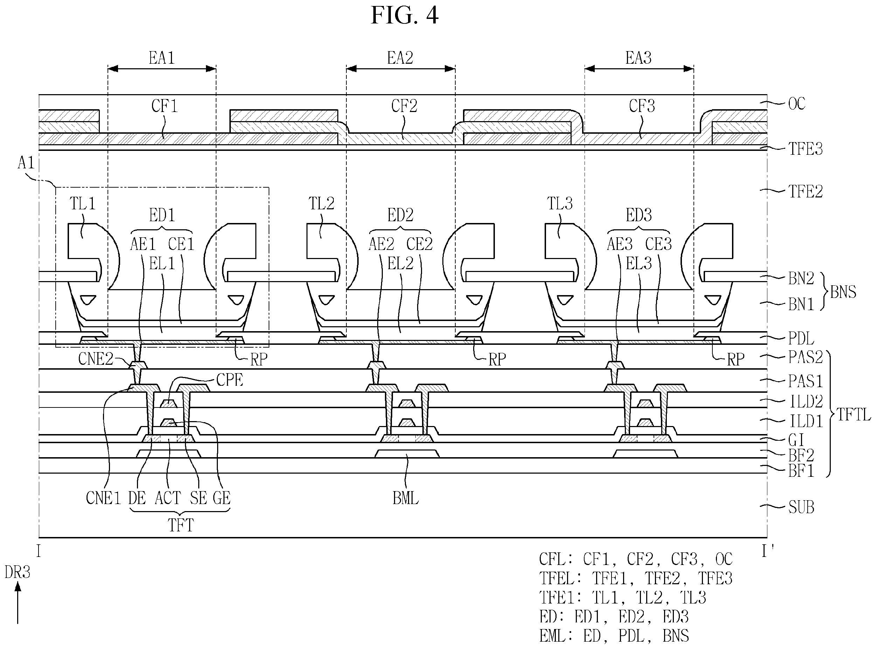

The first to third emission areas EA1, EA2, and EA3 may be defined by an inorganic pixel defining layer PDL (see FIG. 4) to be described later, respectively.

FIG. 4 is a cross-sectional view illustrating a portion of the display device according to an embodiment. Specifically, FIG. 4 is a cross-sectional view taken along line I-I' of FIG. 3, and illustrates cross sections of the substrate SUB, the thin film transistor layer TFTL, the light emitting element layer EML, the thin film encapsulation layer TFEL, and the color filter layer CFL.

The thin film transistor layer TFTL may include a first buffer layer BF1, a bottom metal layer BML, a second buffer layer BF2, thin film transistors TFT, a gate insulating layer GI, a first interlayer insulating layer ILD1, capacitor electrodes CPE, a second interlayer insulating layer ILD2, first connection electrodes CNE1, a first passivation layer PAS 1, second connection electrodes CNE2, and a second passivation layer PAS2.

The first buffer layer BF1 may be disposed on the substrate SUB. The first buffer layer BF1 may include an inorganic film capable of preventing permeation of air or moisture. For example, the first buffer layer BF1 may include a plurality of inorganic films that are alternately stacked.

The bottom metal layer BML may be disposed on the first buffer layer BF1. For example, the bottom metal layer may be formed as a single layer or multiple layers formed of any one of molybdenum (Mo), aluminium (Al), chromium (Cr), gold (Au), titanium (Ti), nickel (Ni), neodymium (Nd), and copper (Cu), or alloys thereof.

The second buffer layer BF2 may cover the first buffer layer BF1 and the bottom metal layer BML. The second buffer layer BF2 may include an inorganic film capable of preventing permeation of air or moisture. For example, the second buffer layer BF2 may include a plurality of inorganic films that are alternately stacked.

The thin film transistor TFT may be disposed on the second buffer layer BF2, and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the bottom metal layer BML and the gate electrode GE in the thickness direction DR3, and may be insulated from the gate electrode GE by the gate insulating layer GI. The source electrode SE and the drain electrode DE may be formed by making a material of the semiconductor layer ACT in portions of the semiconductor layer ACT conductors.

The gate electrode GE may be disposed on the gate insulating layer GI. The gate electrode GE may overlap the semiconductor layer ACT in the thickness direction DR3 with the gate insulating layer GI interposed between the gate electrode GE and the semiconductor layer ACT.

The gate insulating layer GI may be disposed on the semiconductor layer ACT. For example, the gate insulating layer GI may cover the semiconductor layer ACT and the second buffer layer BF2, and may insulate the semiconductor layer ACT and the gate electrode GE from each other. The gate insulating layer GI may include contact holes through which the first connection electrodes CNE1 penetrate.

The first interlayer insulating layer ILD 1 may cover the gate electrode GE and the gate insulating layer GI. The first interlayer insulating layer ILD 1 may include contact holes through which the first connection electrodes CNE1 penetrate. The contact holes of the first interlayer insulating layer ILD1 may be connected to the contact holes of the gate insulating layer GI and contact holes of the second interlayer insulating layer ILD2.

The capacitor electrodes CPE may be disposed on the first interlayer insulating layer ILD1. The capacitor electrode CPE may overlap the gate electrode GE in the thickness direction DR3. The capacitor electrode CPE and the gate electrode GE may form capacitance.

The second interlayer insulating layer ILD2 may cover the capacitor electrodes CPE and the first interlayer insulating layer ILD1. The second interlayer insulating layer ILD2 may include contact holes through which the first connection electrodes CNE1 penetrate. The contact holes of the second interlayer insulating layer ILD2 may be connected to the contact holes of the first interlayer insulating layer ILD 1 and the contact holes of the gate insulating layer GI.

The first connection electrodes CNE1 may be disposed on the second interlayer insulating layer ILD2. The first connection electrode CNE1 may electrically connect the drain electrode DE of the thin film transistor TFT and the second connection electrode CNE2 to each other. The first connection electrode CNE1 may be inserted into the contact holes formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrodes CNE1 and the second interlayer insulating layer ILD2. The first passivation layer PAS1 may protect the thin film transistors TFT. The first passivation layer PAS1 may include contact holes through which the second connection electrodes CNE2 penetrate.

The second connection electrodes CNE2 may be disposed on the first passivation layer PAS 1. The second connection electrodes CNE2 may electrically connect the first connection electrodes CNE1 and pixel electrodes AE1, AE2, and AE3 of light emitting elements ED to each other. The second connection electrode CNE2 may be inserted into the contact hole formed in the first passivation layer PAS1 to be in contact with the first connection electrode CNE1.

The second passivation layer PAS2 may cover the second connection electrodes CNE2 and the first passivation layer PAS1. The second passivation layer PAS2 may include contact holes through which the pixel electrodes AE1, AE2, and AE3 of the light emitting elements ED penetrate.

The light emitting element layer EML may be disposed on the thin film transistor layer TFTL. The light emitting element layer EML may include the light emitting elements ED, an inorganic pixel defining layer PDL, and a bank structure BNS. The light emitting elements ED may include the pixel electrodes AE1, AE2, and AE3, light emitting layers EL1, EL2, and EL3, and common electrodes CE1, CE2, and CE3.

FIG. 5 is an enlarged view illustrating a first emission area, specifically, area A1, of FIG. 4.

Referring to FIG. 5 in addition FIG. 4, the display device 10 may include a plurality of emission areas EA1, EA2, and EA3 disposed in the display area DA. The emission areas EA1, EA2, and EA3 may be defined areas where the pixel electrodes AE1, AE2, and AE3, the light emitting layers EL1, EL2, and EL3, and the common electrodes CE1, CE2, and CE3 overlap each other in the thickness direction DR3 of the substrate SUB. The emission areas EA1, EA2, and EA3 may include areas where light is emitted from the light emitting elements ED1, ED2, and ED3 in which the pixel electrodes AE1, AE2, and AE3, the light emitting layers EL1, EL2, and EL3, and the common electrodes CE1, CE2, and CE3 are sequentially stacked, respectively, and passes to the color filter layer CFL in the third direction DR3. The emission areas EA1, EA2, and EA3 may include first emission areas EA1, second emission areas EA2, and third emission areas EA3 that are spaced apart from each other and emit light of the same color or different colors.

In an embodiment, areas or sizes of the first to third emission areas EA1, EA2, and EA3 may be the same as each other. For example, in the display device 10, the first emission area EA1, the second emission area EA2, and the third emission area EA3 may have the same area. However, embodiments of the present disclosure are not limited thereto. In the display device 10, areas or sizes of the first to third emission areas EA1, EA2, and EA3 may be different from each other. For example, an area of the second emission area EA2 may be greater than areas of the first emission area EA1 and the third emission area EA3, and an area of the third emission area EA3 may be greater than an area of the first emission area EA1. Intensities of the light emitted from the emission areas EA1, EA2, and EA3 may be changed depending on the areas of the emission areas EA1, EA2, and EA3, and a color feeling of a screen displayed on the display device 10 may be controlled by adjusting the areas of the emission area EA1, EA2, and EA3. In an embodiment of FIG. 4, it has been illustrated that the areas of the emission areas EA1, EA2, and EA3 are the same as each other, but embodiments of the present disclosure are not limited thereto.

In the display device 10, one first emission area EA1, one second emission area EA2, and one third emission area EA3 disposed adjacent to each other may form one pixel group. One pixel group may include the emission areas EA1, EA2, and EA3 emitting light of different colors to express a white gradation. However, embodiments of the present disclosure are not limited thereto, and a combination of the emission areas EA1, EA2, and EA3 constituting one pixel group may be variously modified depending on an arrangement of the emission areas EA1, EA2, and EA3, colors of the light emitted by the emission areas EA1, EA2, and EA3, and the like.

The display device 10 may include a plurality of light emitting elements ED1, ED2, and ED3 disposed in different emission areas EA1, EA2, and EA3. The light emitting elements ED1, ED2, and ED3 may include a first light emitting element ED1 disposed in the first emission area EA1, a second light emitting element ED2 disposed in the second emission area EA2, and a third light emitting element ED3 disposed in the third emission area EA3.

The light emitting elements ED1, ED2, and ED3 may include pixel electrodes AE1, AE2, and AE3, light emitting layers EL1, EL2, and EL3, and common electrodes CE1, CE2, and CE3, respectively, and the light emitting elements ED1, ED2, and ED3 disposed in the different emission areas EA1, EA2, and EA3 may emit light of different colors depending on materials of the light emitting layers EL1, EL2, and EL3, respectively. For example, the first light emitting element ED1 disposed in the first emission area EA1 may emit red light having a peak wavelength in the range of 610 nm to 650 nm, the second light emitting element ED2 disposed in the second emission area EA2 may emit green light having a peak wavelength in the range of 510 nm to 550 nm, and the third light emitting element ED3 disposed in the third emission area EA3 may emit blue light having a peak wavelength in the range of 440 nm to 480 nm. The first to third emission areas EA1, EA2, and EA3 constituting one pixel may include the light emitting elements ED1, ED2, and ED3 emitting the light of the different colors to express a white gradation. Alternatively, the light emitting layers EL1, EL2, and EL3 may include two or more materials emitting the light of the different colors, such that one light emitting layer may emit mixed light. For example, the light emitting layers EL1, EL2, and EL3 may include both of a red light emitting material and a green light emitting material to emit yellow light or include all of a red light emitting material, a green light emitting material, and a blue light emitting material to emit white light.

The pixel electrodes AE1, AE2, and AE3 may be disposed on the second passivation layer PAS2. The pixel electrodes AE1, AE2, and AE3 may be disposed in the plurality of emission areas EA1, EA2, and EA3, respectively. The pixel electrodes AE1, AE2, and AE3 may include a first pixel electrode AE1 disposed in the first emission area EA1, a second pixel electrode AE2 disposed in the second emission area EA2, and a third pixel electrode AE3 disposed in the third emission area EA3. The first pixel electrode AE1, the second pixel electrode AE2, and the third pixel electrode AE3 may be disposed to be spaced apart from each other on the second passivation layer PAS2, respectively.

The pixel electrodes AE1, AE2, and AE3 may be electrically connected to the drain electrodes DE of the thin film transistors TFT through the first and second connection electrodes CNE1 and CNE2. Edges of the pixel electrodes AE1, AE2, and AE3 spaced apart from each other are covered by the inorganic pixel defining layer PDL, such that the first to third pixel electrodes AE1, AE2, and AE3 may be insulated from each other.

The inorganic pixel defining layer PDL may be disposed on the second passivation layer PAS2, residual patterns RP, and the pixel electrodes AE1, AE2, and AE3. The inorganic pixel defining layer PDL may be entirely disposed on the second passivation layer PAS2, and may cover side surfaces of the pixel electrodes AE1, AE2, and AE3 and the residual patterns RP and expose portions of upper surfaces of the pixel electrodes AE1, AE2, and AE3. For example, the inorganic pixel defining layer PDL may expose the first pixel electrode AE1 in the first emission area EA1, and a first light emitting layer EL1 may be directly disposed on the first pixel electrode AE1.

The inorganic pixel defining layer PDL may include an inorganic insulating material. The inorganic pixel defining layer PDL may include at least one of silicon nitride, silicon oxynitride, silicon oxide, titanium oxide, aluminium oxide, tantalum oxide, hafnium oxide, zinc oxide, and amorphous silicon, but is not limited thereto.

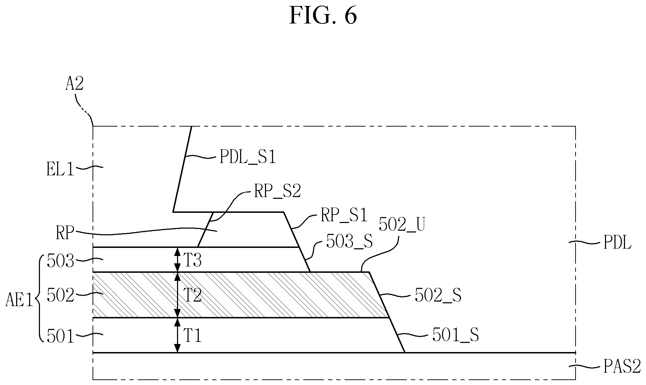

FIG. 6 is an enlarged view illustrating area A2 of FIG. 5. Area A2 relates to a boundary between the first pixel electrode AE1 and the inorganic pixel defining layer PDL.

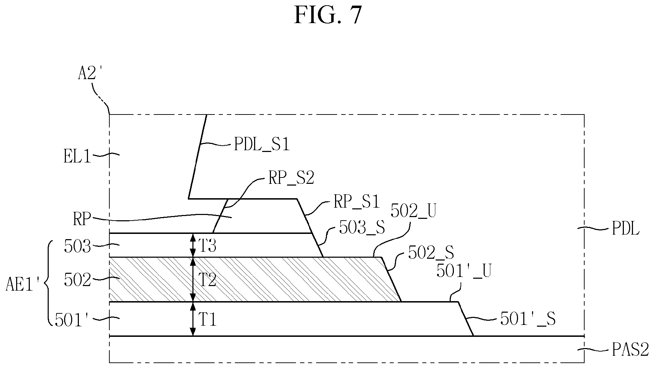

FIG. 7 is a cross-sectional view illustrating a portion of the display device according to an embodiment, and is an enlarged view illustrating area A2' corresponding to area A2. The pixel electrodes AE1, AE2, and AE3 will be described using the first pixel electrode AE1 as an example.

Each of the pixel electrodes AE1, AE2, and AE3 may include a transparent electrode material and/or a conductive metal material, and may have a single-layer or multilayer structure. In an embodiment, each of the pixel electrodes AE1, AE2, and AE3 may include a lower transparent electrode layer 501, a metal electrode layer 502, and an upper transparent electrode layer 503 that are sequentially stacked.

The lower transparent electrode layer 501 may be disposed on the second passivation layer PAS2, and the metal electrode layer 502 may be disposed on the lower transparent electrode layer 501.

A side surface 501_S of the lower transparent electrode layer 501 may be aligned with a side surface 502_S of the metal electrode layer 502 or may protrude more than the side surface 502_S of the metal electrode layer 502. In other words, the lower transparent electrode layer 501 may have the same width as or a greater width than the metal electrode layer 502 at an interface with the metal electrode layer 502. In this case, the width may be a distance between one end and the other end of each layer in one direction of the substrate SUB.

When the side surface of the lower transparent electrode layer is indented more than the side surface of the metal electrode layer or the side surface of the metal electrode layer protrudes more than the side surface of the lower transparent electrode layer, the lower transparent electrode layer may have an undercut structure and a portion of a lower surface of the metal electrode layer may be exposed. In an example in which the inorganic pixel defining layer is formed on the pixel electrode, the inorganic pixel defining layer may not be formed continuously and a gap may be formed, at a boundary of the undercut structure of the lower transparent electrode layer. Such a gap may become a moisture permeation path.

When the side surface 501_S of the lower transparent electrode layer 501 is aligned with the side surface 502_S of the metal electrode layer 502 or protrudes more than the side surface 502_S of the metal electrode layer 502, the inorganic pixel defining layer PDL may be formed continuously without being disconnected at a boundary with the lower transparent electrode layer 501 and the metal electrode layer 502. Accordingly, the moisture permeation path may be blocked.

It has been illustrated in FIG. 6 that the side surface 501_S of the lower transparent electrode layer 501 is aligned with the side surface 502_S of the metal electrode layer 502, and it has been illustrated in FIG. 7 that a side surface 501'_S of a lower transparent electrode layer 501' protrudes more than the side surface 502_S of the metal electrode layer 502 in a direction away from each of the emission areas EA1, EA2, and EA3. At least a portion of an upper surface 501'_U or an edge of the lower transparent electrode layer 501' may be exposed and not be covered by the metal electrode layer 502, and the side surface 501'_S of the lower transparent electrode layer 501' may protrude more than the side surface 502_S of the metal electrode layer 502. The exposed upper surface 501'_U of the lower transparent electrode layer 501' may be covered with the inorganic pixel defining layer PDL.

Referring to FIGS. 6 and 7, the upper transparent electrode layer 503 may be disposed on the metal electrode layer 502. The side surface 502_S of the metal electrode layer 502 may protrude from a side surface 503_S of the upper transparent electrode layer 503 in the direction away from each of the emission areas EA1, EA2, and EA3. In other words, the metal electrode layer 502 may have a greater width than the upper transparent electrode layer 503 at a boundary with the upper transparent electrode layer 503. At least a portion of an upper surface 502_U or an edge of the metal electrode layer 502 may be exposed and not covered by the upper transparent electrode layer 503. The exposed upper surface 502_U of the metal electrode layer 502 may be covered with the inorganic pixel defining layer PDL.

In an embodiment, the lower transparent electrode layer 501 and the upper transparent electrode layer 503 may respectively include different transparent conductive oxides (TCO). For example, the lower transparent electrode layer 501 and the upper transparent electrode layer 503 respectively including different materials may have different etch rates or reactivities, such that electrode layers having different widths may be formed. The transparent conductive oxide (TCO) may be one or more of indium tin oxide (ITO), indium zinc oxide (IZO), indium tin zinc oxide (ITZO), zinc indium tin oxide (ZITO), indium gallium zinc oxide (IGZO), and zinc tin oxide (ZTO).

In an embodiment, the lower transparent electrode layer 501 may include zinc indium tin oxide (ZITO), and the upper transparent electrode layer 503 may include indium tin oxide (ITO). The lower transparent electrode layer 501 may be amorphous. The upper transparent electrode layer 503 may be amorphous.

According to an embodiment, a ratio of zinc (Zn) to the total number of metal atoms included in the lower transparent electrode layer 501 may be 25 at% to 45 at%. According to an example, the ratio of zinc (Zn) to the total number of metal atoms included in the lower transparent electrode layer 501 may be 30 at% to 40 at%. In an example in which the ratio of zinc (Zn) is included in the above range, amorphous characteristics of the lower transparent electrode layer 501 may be maintained.

According to an embodiment, a ratio of tin (Sn) to the total number of metal atoms included in the lower transparent electrode layer 501 may be 15 at% to 35 at%. According to an example, the ratio of tin (Sn) to the total number of metal atoms included in the lower transparent electrode layer 501 may be 20 at% to 30 at%. In an example in which the ratio of tin (Sn) is included in the above range, a selectivity for an etchant used in an etching process of the upper transparent electrode layer 503 and the metal electrode layer 502 is high, and the lower transparent electrode layer 501 is hardly damaged in the etching process. However, when the ratio of tin (Sn) to the total number of metal atoms is less than 15 at%, an etch rate increases, such that the selectivity decreases. In an example in which the ratio of tin (Sn) to the total number of metal atoms is greater than 35 at%, it is difficult to control particle characteristics.

According to an embodiment, a ratio of indium (In) to the total number of metal atoms included in the lower transparent electrode layer 501 may be 30 at% to 50 at%. According to an example, the ratio of indium (In) to the total number of metal atoms included in the lower transparent electrode layer 501 may be 35 at% to 45 at%. In an example in which the ratio of indium (In) is included in the above range, a work function of the lower transparent electrode layer 501 targeted for implementing (e.g., required as) the pixel electrodes AE1, AE2, and AE3 may be maintained.

The metal atoms included in the lower transparent electrode layer 501 may be zinc (Zn), indium (In), and tin (Sn). The sum of atomic ratios of zinc (Zn), indium (In), and tin (Sn) to the total number of metal atoms included in the lower transparent electrode layer 501 may be 100 at%. In the total number of metal atoms included in the lower transparent electrode layer 501, the number of oxygen is excluded. Elemental ratios or atomic ratios may be obtained by X-ray photoelectron spectroscopy (XPS).

For example, X-ray phototelectron spectroscopy (XPS) can find out the elemental composition, chemical bonding state, electronic state, etc. of the sample by measuring the kinetic energy of the emitted photoelectrons by irradiating X-rays to the surface of the sample. Specifically, the lower transparent electrode layer 501 sample is introduced into a high vacuum chamber (for example, 10⁻⁹ torr), and moisture contained in the lower transparent electrode layer 501 is removed through a pump, and then X-rays are irradiated to measure the elemental ratios or atomic ratios of the sample.

The metal electrode layer 502 may include a metal material and reflect light. The metal material may be one or more of silver (Ag), copper (Cu), aluminium (Al), nickel (Ni), lanthanum (La), titanium (Ti), titanium nitride (TiN), and molybdenum (Mo).

The lower transparent electrode layer 501 and the upper transparent electrode layer 503 may have different thicknesses. In an embodiment, a thickness T1 of the lower transparent electrode layer 501 may be greater than a thickness T3 of the upper transparent electrode layer 503. A thickness T2 of the metal electrode layer 502 may be greater than each of the thickness T1 of the lower transparent electrode layer 501 and the thickness T3 of the upper transparent electrode layer 503. In an embodiment, the thickness of the lower transparent electrode layer 501 may be 1 nm to 25 nm. In an example in which the thickness of the lower transparent electrode layer 501 is included in the above range, the lower transparent electrode layer 501 may attach the second passivation layer PAS2 and the metal electrode layer 502 to each other between the second passivation layer PAS2 and the metal electrode layer 502 while having amorphous characteristics. In an embodiment, the thickness T2 of the metal electrode layer 502 may be 70 nm to 100 nm.

The inorganic pixel defining layer PDL may be disposed on the pixel electrodes AE1, AE2, and AE3, but may be spaced apart from the upper surfaces of the pixel electrodes AE1, AE2, and AE3. The inorganic pixel defining layer PDL may not be in direct contact with the upper surfaces of the pixel electrodes AE1, AE2, and AE3 while partially overlapping the upper surfaces of the pixel electrodes AE1, AE2, and AE3 in the thickness direction DR3 of the substrate SUB, and the residual patterns RP may be disposed between a lower surface of the inorganic pixel defining layer PDL and the upper transparent electrode layers 503 of the pixel electrodes AE1, AE2, and AE3. However, the inorganic pixel defining layer PDL may be in direct contact with the side surfaces of the pixel electrodes AE1, AE2, and AE3.

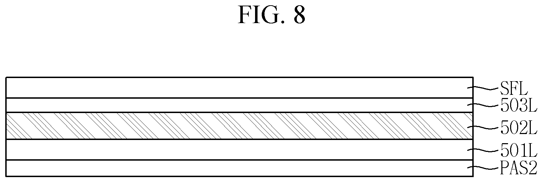

The residual pattern RP may be disposed on an edge of the upper transparent electrode layer 503 of each of the pixel electrodes AE1, AE2, and AE3. The residual patterns RP may be formed by removing portions of sacrificial layers SFL (see FIG. 8) disposed on the pixel electrodes AE1, AE2, and AE3 in processes for fabrication of the display device 10.

The residual pattern RP may include a metal material or a transparent conductive oxide (TCO). The metal material or the transparent conductive oxide (TCO) included in the residual patterns RP may be the metal material or the transparent conductive oxide (TCO) material described as the material of the pixel electrodes AE1, AE2, and AE3. In an embodiment, the residual pattern RP may be indium tin oxide (ITO), zinc indium tin oxide (ZITO), or indium gallium zinc oxide (IGZO).

The residual pattern RP may include a first side surface RP_S1 facing the direction away from each of the emission areas EA1, EA2, and EA3, and a second side surface RP_S2 facing each of the emission areas EA1, EA2, and EA3. In an embodiment, the first side surface RP_S1 of the residual pattern RP may be aligned with the side surface 503_S of the upper transparent electrode layer 503 of each of the pixel electrodes AE1, AE2, and AE3. The second side surface RP_S2 of the residual pattern RP may face each of the light emitting layers EL1, EL2, and EL3. It has been illustrated in FIG. 6 that the second side surface RP_S2 of the residual pattern RP is recessed more than a first side surface of the inorganic pixel defining layer PDL, but embodiments of the present disclosure are not limited thereto. The second side surface RP_S2 of the residual pattern RP may be indented more than a first side surface PDL_S1 of the inorganic pixel defining layer PDL or may be aligned with the first side surface PDL_S1 of the inorganic pixel defining layer PDL. The first side surface PDL_S1 of the inorganic pixel defining layer PDL may be a side surface positioned at the outermost portion toward each of the emission areas EA1, EA2, and EA3, a side surface closest to the center of each of the emission areas EA1, EA2, and EA3, or a side surface adjacent to a first bank BN1.

Referring to FIGS. 6 and 7, the inorganic pixel defining layer PDL may further include a first lower surface connected to the first side surface PDL_S1 and facing an upper surface of the residual pattern RP, a second side surface connected to the first lower surface and facing the first side surface RP_S1 of the residual pattern RP and the side surface 503_S of the upper transparent electrode layer 503, a second lower surface connected to the second side surface and facing the upper surface 502_U of the metal electrode layer 502, and a third side surface connected to the second lower surface and facing the side surface 502_S of the metal electrode layer 502. The first side surface PDL_S1 of the first to third side surfaces of the inorganic pixel defining layer PDL may be closest to the center of each of the emission area EA1, EA2, and EA3, and the second side surface of the first to third side surfaces of the inorganic pixel defining layer PDL may protrude more than the third side surface toward each of the emission areas EA1, EA2, and EA3. The first lower surface of the inorganic pixel defining layer PDL may be positioned at a higher level than the second lower surface of the inorganic pixel defining layer PDL.

Referring to FIG. 7, the inorganic pixel defining layer PDL may further include a third lower surface connected to the third side surface and facing the upper surface 501'_U of the lower transparent electrode layer 501' and a fourth side surface connected to the third lower surface and facing the side surface 501'_S of the lower transparent electrode layer 501'. The third side surface of the inorganic pixel defining layer PDL may protrude more than the fourth side surface of the inorganic pixel defining layer PDL toward each of the emission areas EA1, EA2, and EA3. The second lower surface of the inorganic pixel defining layer PDL may be positioned at a higher level than the third lower surface of the inorganic pixel defining layer PDL.

The light emitting layers EL1, EL2, and EL3 may be disposed on the pixel electrodes AE1, AE2, and AE3, respectively. The light emitting layers EL1, EL2, and EL3 may be organic light emitting layers formed of an organic material, and may be formed on the pixel electrodes AE1, AE2, and AE3, respectively, through a deposition process. The light emitting layers EL1, EL2, and EL3 may each have a multilayer structure, and a hole injection material, a hole transporting material, a light emitting material, an electron transporting material, and/or an electron injection material may constitute layers of the light emitting layers EL1, EL2, and EL3, respectively. In an example in which the thin film transistors TFT apply predetermined voltages to the pixel electrodes AE1, AE2, and AE3 of the light emitting elements ED1, ED2, and ED3 and the common electrodes CE1, CE2, and CE3 of the light emitting elements ED1, ED2, and ED3 receive a common voltage or a cathode voltage, holes and electrons may be injected and transported, respectively, and may be combined with each other in the light emitting layers EL1, EL2, and EL3 to emit light.

The light emitting layers EL1, EL2, and EL3 may include a first light emitting layer EL1, a second light emitting layer EL2, and a third light emitting layer EL3 respectively disposed in the different emission areas EA1, EA2, and EA3. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. A plurality of light emitting layers EL1, EL2, and EL3 may emit light of different colors, respectively, or one light emitting layer EL1, EL2, or EL3 may emit mixed light. In an embodiment, the first light emitting layer EL1 may emit red light, the second light emitting layer EL2 may emit green light, and the third light emitting layer EL3 may emit blue light. In another embodiment, the first light emitting layer EL1 may emit yellow light, which is mixed light of red light and green light, and the second light emitting layer EL2 may emit blue light. In still another embodiment, the first light emitting layer EL1 may emit white light, which is mixed light of red light, green light, and blue light.

The light emitting layers EL1, EL2, and EL3 may be disposed on an upper surface of the inorganic pixel defining layer PDL. In an embodiment, portions of the light emitting layers EL1, EL2, and EL3 may be disposed in spaces between the pixel electrodes AE1, AE2, and AE3 and the inorganic pixel defining layer PDL. In an embodiment, the light emitting layers EL1, EL2, and EL3 may be in contact with the inorganic pixel defining layer PDL, the residual patterns RP, and the pixel electrodes AE1, AE2, and AE3.

The common electrodes CE1, CE2, and CE3 may be disposed on the light emitting layers EL1, EL2, and EL3, respectively. The common electrodes CE1, CE2, and CE3 may include a transparent conductive material to emit the light generated from the light emitting layers EL1, EL2, and EL3. The common electrodes CE1, CE2, and CE3 may receive a common voltage or a low potential voltage. In an example in which the pixel electrodes AE1, AE2, and AE3 receive voltages corresponding to data voltages and the common electrodes CE1, CE2, and CE3 receive the low potential voltage, potential differences are formed between the pixel electrodes AE1, AE2, and AE3 and the common electrodes CE1, CE2, and CE3, such that the light emitting layers EL1, EL2, and EL3 may emit the light.

The common electrodes CE1, CE2, and CE3 may include a first common electrode CE1, a second common electrode CE2, and a third common electrode CE3 respectively disposed in the different emission areas EA1, EA2, and EA3. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3. The first to third common electrodes CE1, CE2, and CE3 may be spaced apart from each other. One of the ends and the other of the ends of the first to third common electrodes CE1, CE2, and CE3 may be in contact with side surfaces of the first bank BN1.

A capping layer (not illustrated) may be optionally disposed on the common electrodes CE1, CE2, and CE3. The capping layer may include an organic or inorganic insulating material and cover patterns disposed on the light emitting elements ED1, ED2, and ED3. The capping layer may prevent the light emitting elements ED1, ED2, and ED3 from being damaged by external air. In an embodiment, the capping layer may include an organic material such as, for example, α-NPD, NPB, TPD, m-MTDATA, Alq₃, LiF, and/or CuPc, or an inorganic material such as, for example, aluminium oxide, titanium oxide, tantalum oxide, hafnium oxide, zinc oxide, silicon oxide, silicon nitride, and/or silicon oxynitride.

The display device 10 may include a plurality of bank structures BNS disposed on the inorganic pixel defining layer PDL. The bank structure BNS may have a structure in which banks BN1 and BN2 respectively including different materials are sequentially stacked, may include a plurality of openings including the emission areas EA1, EA2, and EA3, and may be disposed to overlap light blocking areas of a color filter layer CFL to be described later. The light emitting elements ED1, ED2, and ED3 of the display device 10 may be disposed to overlap the openings of the bank structure BNS.

The first bank BN1 may be disposed on the inorganic pixel defining layer PDL. Side surfaces of the first bank BN1 may be recessed more than side surfaces of the inorganic pixel defining layer PDL in a direction opposite to a direction toward the emission areas EA1, EA2, and EA3. The side surfaces of the first bank BN1 may be recessed more than side surfaces of a second bank BN2 to be described later in the direction opposite to the direction toward the emission areas EA1, EA2, and EA3.

According to an embodiment, the first bank BN1 may include a metal material. In an embodiment, the first bank BN1 may include aluminium (Al), oxide of aluminium (Al), or an alloy of aluminium (Al).

The side surfaces of the first bank BN1 may be in direct contact with the light emitting layers EL1, EL2, and EL3 and the common electrodes CE1, CE2, and CE3. Contact areas between the common electrodes CE1, CE2, and CE3 and the side surfaces of the first bank BN1 may be greater than contact areas between the light emitting layers EL1, EL2, and EL3 and the side surfaces of the first bank BN1. The common electrodes CE1, CE2, and CE3 may be disposed to have a greater area than the light emitting layers EL1, EL2, and EL3 on the side surfaces of the first bank BN1 or may be disposed up to a greater height than the light emitting layers EL1, EL2, and EL3 on the side surfaces of the first bank BN1. Since the common electrodes CE1, CE2, and CE3 of the different light emitting elements ED1, ED2, and ED3 are electrically connected to each other through the first bank BN1, it may be advantageous that the common electrodes CE1, CE2, and CE3 are in contact with the first bank BN1 in a greater area. The first bank BN1 may have an upper surface at a higher position than the common electrodes CE1, CE2, and CE3. A height from the substrate SUB to the upper surface of the first bank BN1 may be greater than a height from the substrate SUB to the common electrodes CE1, CE2, and CE3.

The second bank BN2 may be disposed on the first bank BN1. The second bank BN2 may include openings overlapping the respective emission areas EA1, EA2, and EA3, and each of the openings may include side surfaces. The second bank BN2 may include tips TIP or eaves, which are areas protruding compared to the first bank BN1. The side surfaces of the second bank BN2 may protrude more than the side surfaces of the first bank BN1 toward the emission areas EA1, EA2, and EA3.

The side surfaces of the second bank BN2 have a shape in which they protrude more than the side surfaces of the first bank BN1 toward the emission areas EA1, EA2, and EA3, and accordingly, undercut structures of the first bank BN1 may be formed under the tips TIP of the second bank BN2.

In the display device 10 according to an embodiment, the bank structure BNS includes the tips TIP protruding toward the emission areas EA1, EA2, and EA3, and thus, the light emitting layers EL1, EL2, and EL3 and the common electrodes CE1, CE2, and CE3 spaced apart from each other may be formed through deposition and etching processes rather than a mask process. In some aspects, embodiments of the present disclosure support forming different layers individually in the different emission areas EA1, EA2, and EA3 even through a deposition process. For example, even though the light emitting layers EL1, EL2, and EL3 and the common electrodes CE1, CE2, and CE3 of the light emitting elements ED1, ED2, and ED3 are formed through a deposition process that does not use a mask, deposited materials may be disconnected from each other with the bank structure BNS interposed between the deposited materials by the tips TIP of the second bank BN2 rather than being connected to each other between the emission areas EA1, EA2, and EA3. Embodiments of the present disclosure support forming the different layers individually in the different emission areas EA1, EA2, and EA3 through a process of forming a material for forming a specific layer on the entire surface of the display device 10 and then etching and removing a layer formed in unwanted areas. In the display device 10, unnecessary components may be omitted, and an area of the non-display area NDA may be minimized.

The second bank BN2 may include a metal material different from the metal material of the first bank BN1. The metal material of the second bank BN2 may be any material that is removed together with the metal material of the first bank BN1 by dry etching, but having an etch rate substantially less than the etch rate of the first bank BN1 with respect to wet etching. In some other examples, the metal material of the second bank BN2 may be any material that is not etched with respect to wet etching. In an embodiment, the first bank BN1 includes aluminium (Al), oxide of aluminium (Al), or an alloy of aluminium (Al), and the second bank BN2 may include titanium (Ti), oxide of titanium (Ti), or an alloy of titanium (Ti).

The tips TIP of the second bank BN2 may overlap the common electrodes CE1, CE2, and CE3, the light emitting layer EL1, EL2, and EL3, and the inorganic pixel defining layer PDL in a direction DR3 perpendicular to the substrate SUB. The common electrodes CE1, CE2, and CE3 may be formed under lower surfaces of the tips TIP of the second bank BN2. One of the ends and the other of the ends of the common electrodes CE1, CE2, and CE3 may overlap the second bank BN2 in the thickness direction DR3 of the substrate.

The thin film encapsulation layer TFEL may be disposed on the light emitting elements ED1, ED2, and ED3 and the bank structure BNS, and may cover the plurality of light emitting elements ED1, ED2, and ED3 and the bank structure BNS. The thin film encapsulation layer TFEL may include at least one inorganic film to prevent oxygen or moisture from permeating into the light emitting element layer EML. The thin film encapsulation layer TFEL may include at least one organic film to protect the light emitting element layer EML from foreign substances such as, for example, dust.

In an embodiment, the thin film encapsulation layer TFEL may include a lower inorganic encapsulation layer TFE1, an organic encapsulation layer TFE2, and an upper inorganic encapsulation layer TFE3 that are sequentially stacked.

Each of the lower inorganic encapsulation layer TFE1 and the upper inorganic encapsulation layer TFE3 may include one or more inorganic insulating materials. The inorganic insulating material may be any one of silicon oxide, silicon nitride, and silicon oxynitride, and may be, for example, aluminium oxide, titanium oxide, tantalum oxide, hafnium oxide, zinc oxide, silicon oxide, silicon nitride, and/or silicon oxynitride.

The organic encapsulation layer TFE2 may include a polymer-based material. The polymer-based material may include an acrylic resin, an epoxy-based resin, polyimide, polyethylene, and the like. For example, the organic encapsulation layer TFE2 may include an acrylic resin such as, for example, polymethyl methacrylate or polyacrylic acid. The organic encapsulation layer TFE2 may be formed by curing a monomer or applying a polymer.

The lower inorganic encapsulation layer TFE1 may be disposed on the light emitting elements ED1, ED2, and ED3 and the bank structure BNS. The lower encapsulation layer TFE1 may include a first inorganic layer TL1, a second inorganic layer TL2, and a third inorganic layer TL3 disposed to respectively correspond to the different emission areas EA1, EA2, and EA3. The first inorganic layer TL1, the second inorganic layer TL2, and the third inorganic layer TL3 may include an inorganic insulating material and cover the light emitting elements ED1, ED2, and ED3, respectively. The first inorganic layer TL1, the second inorganic layer TL2, and the third inorganic layer TL3 may prevent the light emitting elements ED1, ED2, and ED3 from being damaged by external air.

The lower inorganic encapsulation layers TFE1: TL1, TL2, and TL3 may be formed through chemical vapor deposition (CVD), and may thus be formed along steps of layers on which they are deposited. For example, the first inorganic layer TL1, the second inorganic layer TL2, and the third inorganic layer TL3 may form thin films even under undercuts by the tips TIP of the bank structure BNS. The lower inorganic encapsulation layers TFE1: TL1, TL2, and TL3 may be disposed along an upper surface, the side surfaces, and a lower surface of the second bank BN2, the side surfaces of the first bank BN1, and upper surfaces of the common electrodes CE1, CE2, and CE3. The lower inorganic encapsulation layers TFE1: TL1, TL2, and TL3 may be in contact with the lower surface of the second bank BN2 to prevent moisture permeation from external air.

The first inorganic layer TL1 may not overlap the second light emitting element ED2 and the third light emitting element ED3, and may be disposed such that the first inorganic layer TL1 is only on the first light emitting element ED1 and the bank structure BNS around the first light emitting element ED1. The second inorganic layer TL2 may not overlap the first light emitting element ED1 and the third light emitting element ED3, and may be disposed such that the second inorganic layer TL2 is only on the second light emitting element ED2 and the bank structure BNS around the second light emitting element ED2. The third inorganic layer TL3 may not overlap the first light emitting element ED1 and the second light emitting element ED2, and may be disposed such that the third inorganic layer TL3 is only on the third light emitting element ED3 and the bank structure BNS around the third light emitting element ED3.

The first inorganic layer TL1 may be formed after the first common electrode CE1 is formed, the second inorganic layer TL2 may be formed after the second common electrode CE2 is formed, and the third inorganic layer TL3 may be formed after the third common electrode CE3 is formed. The first inorganic layer TL1, the second inorganic layer TL2, and the third inorganic layer TL3 may be disposed to be spaced apart from each other on the bank structure BNS.

The lower inorganic encapsulation layers TFE1: TL1, TL2, and TL3 may be disposed on the light emitting elements ED1, ED2, and ED3 and the upper surface and the lower surface the second bank BN2 around the light emitting elements ED1, ED2, and ED3, but may be spaced apart from the upper surface of the second bank BN2. That is, each of the lower inorganic encapsulation layers TFE1: TL1, TL2, and TL3 may have an undercut structure on the second bank BN2. Spaces between the lower inorganic encapsulation layers TFE1: TL1, TL2, and TL3 and the upper surface of the second bank BN2 spaced apart from each other may be spaces where materials of the light emitting layers EL1, EL2, and EL3 and the common electrodes CE1, CE2, and CE3 that are entirely deposited are removed.

The organic encapsulation layer TFE2 is disposed on the second bank BN2 and the lower inorganic encapsulation layers TFE1: TL1, TL2, and TL3. Portions of the organic encapsulation layer TFE2 may be disposed in the spaces between the lower inorganic encapsulation layers TFE1: TL1, TL2, and TL3 and the upper surface of the second bank BN2 spaced apart from each other. In areas where the second bank BN2 and the lower inorganic encapsulation layers TFE1: TL1, TL2, and TL3 overlap each other, the second bank BN2, the organic encapsulation layer TFE2, and the lower inorganic encapsulation layers TFE1: TL1, TL2, and TL3 may be sequentially disposed. In areas of the tips TIP, the organic encapsulation layer TFE2 and the lower inorganic encapsulation layers TFE1: TL1, TL2, and TL3 may be sequentially disposed on the second bank BN2, and the organic encapsulation layer TFE2 may be disposed again on the lower inorganic encapsulation layers TFE1: TL1, TL2, and TL3. In other words, portions of the organic encapsulation layer TFE2 may be disposed between the upper surface of the second bank BN2 and the lower inorganic encapsulation layers TFE1: TL1, TL2, and TL3 on the tips TIP of the second bank BN2, and the other portions of the organic encapsulation layer TFE2 may be disposed on the lower inorganic encapsulation layers TFE1: TL1, TL2, and TL3.

In an embodiment, the entirety of the upper surface of the second bank BN2 may be in contact with the organic encapsulation layer TFE2. First lower surfaces of the lower inorganic encapsulation layers TFE1: TL1, TL2, and TL3 may be surfaces facing the upper surface of the second bank BN2, and may be in contact with the organic encapsulation layer TFE2. The organic encapsulation layer TFE2 may be in contact with the side surfaces of the second bank BN2.

The upper inorganic encapsulation layer TFE3 may be disposed on the organic encapsulation layer TFE2. The upper inorganic encapsulation layer TFE3 may include aluminium oxide, titanium oxide, tantalum oxide, hafnium oxide, zinc oxide, silicon oxide, silicon nitride, and/or silicon oxynitride.

A light blocking layer (not illustrated) may be optionally disposed on the thin film encapsulation layer TFEL. The light blocking layer may be positioned between the emission areas EA1, EA2, and EA3. The light blocking layer may include a light absorbing material. For example, the light blocking layer may include an inorganic black pigment or an organic black pigment. The inorganic black pigment may be carbon black, and the organic black pigment may include at least one of Lactam Black, Perylene Black, and Aniline Black, but embodiments of the present disclosure are not limited thereto. The light blocking layer may prevent color mixing due to permeation of visible light between the first to third emission areas EA1, EA2, and EA3 to improve a color gamut of the display device 10.

The display device 10 may include a plurality of color filters CF1, CF2, and CF3 disposed on the emission areas EA1, EA2, and EA3. Each of the plurality of color filters CF1, CF2, and CF3 may include a filtering pattern area and a light blocking area. The filtering pattern areas may be formed to overlap the emission areas EA1, EA2, and EA3 or the openings of the bank structures BNS, and may form light emitting areas through which the light emitted from the emission areas EA1, EA2, and EA3 is emitted. The light blocking areas are areas where the light may not be transmitted because the plurality of color filters CF1, CF2, and CF3 are stacked.

The color filters CF1, CF2, and CF3 may include a first color filter CF1, a second color filter CF2, and a third color filter CF3 disposed to respectively correspond to the different emission areas EA1, EA2, and EA3. The color filters CF1, CF2, and CF3 may include colorants such as, for example, dyes or pigments absorbing light of wavelength bands other than light of a specific wavelength band, and may be disposed to correspond to the colors of the light emitting from the emission areas EA1, EA2, and EA3. For example, the first color filter CF1 may be a red color filter disposed to overlap the first emission area EA1 and transmitting only the first light, which is the red light, therethrough. The second color filter CF2 may be a green color filter disposed to overlap the second emission area EA2 and transmitting only the second light, which is the green light, therethrough, and the third color filter CF3 may be a blue color filter disposed to overlap the third emission area EA3 and transmitting only the third light, which is the blue light, therethrough.

In the display device 10, the color filters CF1, CF2, and CF3 are disposed to overlap each other, and accordingly, an intensity of reflected light by external light may be reduced. Furthermore, a color feeling of the reflected light by the external light may be controlled by adjusting an arrangement, shapes, areas, and the like, of the color filters CF1, CF2, and CF3 in a plan view.

An overcoat layer OC may be disposed on the color filters CF1, CF2, and CF3 to planarize upper ends of the color filters CF1, CF2, and CF3. The overcoat layer OC may be a colorless light transmitting layer that does not have a color of a visible light band. For example, the overcoat layer OC may include a colorless light transmitting organic material such as, for example, an acrylic resin.

Hereinafter, processes for fabrication of the display device 10 according to an embodiment will be described with reference to other drawings. FIGS. 8 to 16 are detailed cross-sectional views sequentially illustrating processes for fabrication of the display device according to an embodiment.

Processes of forming of the pixel electrodes AE1, AE2, and AE3, the inorganic pixel defining layer PDL, and the bank structure BNS as the light emitting element layer EML of the display device 10 have been schematically illustrated in FIGS. 8 to 16. Hereinafter, a description of processes of forming respective layers among the processes for fabrication of the display device 10 will be omitted, and the order of forming the respective layers will be described.

Example aspects of a method and processes supported by aspects of the present disclosure are described with reference to FIGS. 8 to 16. In the descriptions of the method and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

Referring to FIG. 8, the method may include entirely forming a lower transparent electrode material layer 501L, a metal electrode material layer 502L, an upper transparent electrode material layer 503L, and a sacrificial layer SFL on the second passivation layer PAS2.

Although not illustrated in FIG. 8, the thin film transistor layer TFTL may be disposed on the substrate SUB, and a structure of the thin film transistor layer TFTL is the same as that described herein with reference to FIG. 4. A detailed description thereof is omitted.

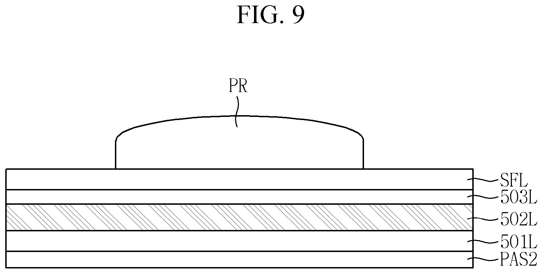

Subsequently, referring to FIG. 9, the method may include forming a photoresist PR on the sacrificial layer SFL. The photoresist PR is disposed to overlap areas that will later become the emission areas EA1, EA2, and EA3.

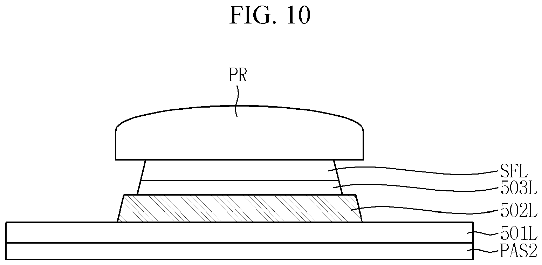

Next, referring to FIG. 10, the method may include performing a first etching process of etching the sacrificial layer SFL, the upper transparent electrode material layer 503L, and the metal electrode material layer 502L using the photoresist PR as a mask. The sacrificial layer SFL and the upper transparent electrode material layer 503L each have a higher etch rate than the metal electrode material layer 502L with respect to an etchant of the first etching process, such that removed areas of the sacrificial layer SFL and the upper transparent electrode material layer 503L may be greater than a removed area of the metal electrode material layer 502L. After the first etching process, the metal electrode material layer 502L may have a greater width than the sacrificial layer SFL and the upper transparent electrode material layer 503L, and the metal electrode material layer 502L may have side surfaces protruding more than side surfaces of the sacrificial layer SFL and the upper transparent electrode material layer 503L. The sacrificial layer SFL and the upper transparent electrode material layer 503L may have the same or similar etch rate with respect to the etchant of the first etching process such that, based on the first etching process, the sacrificial layer SFL and the upper transparent electrode material layer 503L may have the same or similar width and include side surfaces aligned with each other. In an embodiment, the first etching process may be wet etching using a fluorine-based etchant.

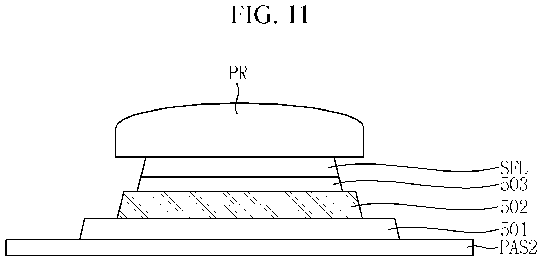

Subsequently, referring to FIG. 11, the method may include performing a second etching process of etching the lower transparent electrode material layer 501L. By controlling the second etching process, the method may adjust an amount of the lower transparent electrode material layer 501L to be removed. It has been illustrated in FIG. 11 that a side surface of the lower transparent electrode layer 501 protrudes more than a side surface of the metal electrode layer 502, but embodiments of the present disclosure are not limited thereto. For example, the side surface of the lower transparent electrode layer 501 may be aligned with the side surface of the metal electrode layer 502 by controlling a condition or the like of the second etching process. Through the first and second etching processes, the method may obtain the pixel electrodes AE1, AE2, and AE3 in which the lower transparent electrode layer 501, the metal electrode layer 502, and the upper transparent electrode layer 503 are sequentially stacked. In an embodiment, the second etching process may be wet etching using a phosphoric acid-based, nitric acid-based, or acetic acid-based etchant.

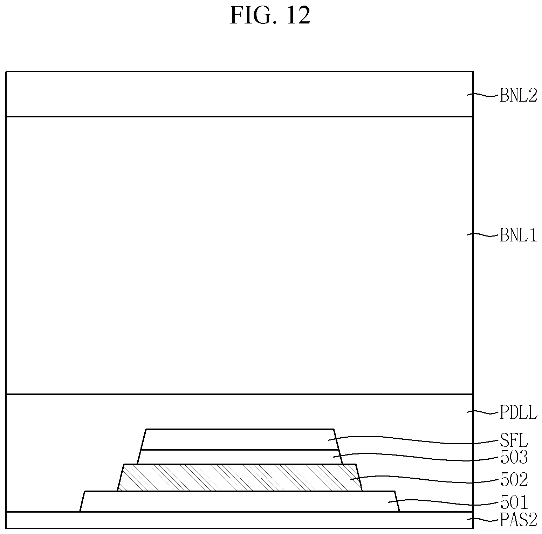

Next, referring to FIG. 12, the method may include sequentially forming an inorganic pixel defining material layer PDLL, a first bank material layer BNL1, and a second bank material layer BNL2 on the second passivation layer PAS2, the pixel electrodes AE1, AE2, and AE3, and the sacrificial layers SFL.

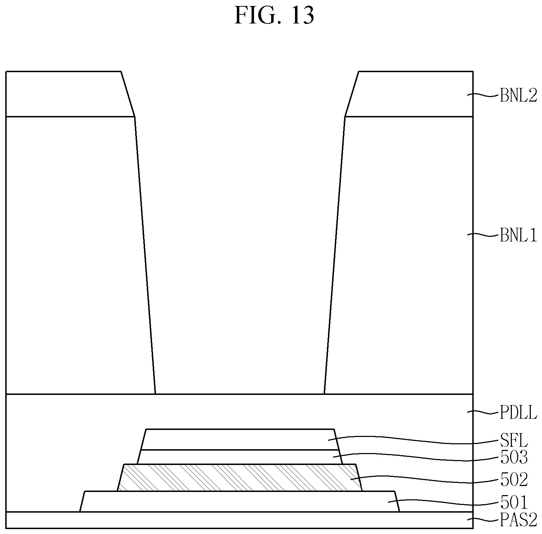

Subsequently, referring to FIG. 13, the method may include performing a third etching process of etching portions of the first and second bank material layers BNL1 and BNL2. Performing the third etching process may include removing the first and second bank material layers BNL1 and BNL2 in areas overlapping the pixel electrodes AE1, AE2, and AE3, exposing the inorganic pixel defining material layer PDLL in the areas overlapping the pixel electrodes AE1, AE2, and AE3.

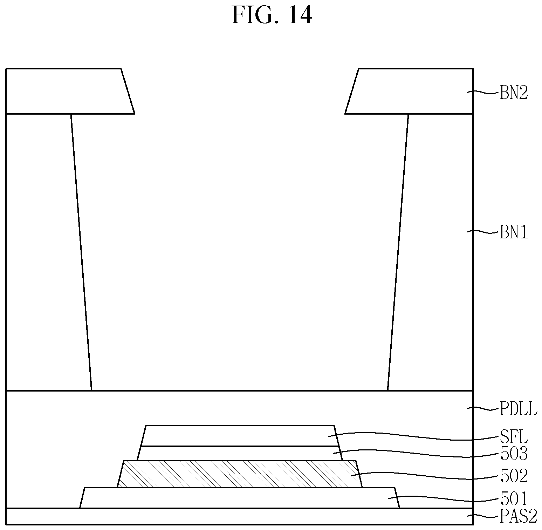

Next, referring to FIG. 14, the method may include performing a fourth etching process which removes the exposed first bank material layer BNL 1. Undercut structures of the first bank BN1 may be formed through the fourth etching process. The first bank material layer BNL1 may have a faster etch rate than the second bank material layer BNL2, and side surfaces of the second bank BN2 may protrude more than side surfaces of the first bank BN1.

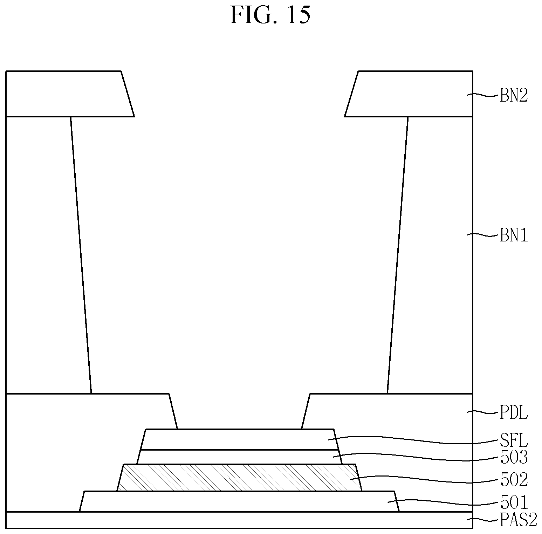

Subsequently, referring to FIG. 15, the method may include performing a fifth etching process which removes the pixel defining material layer PDLL and exposes the sacrificial layers SFL. The fifth etching process may remove portions of the pixel defining material layer PDLL in the areas overlapping the pixel electrodes AE1, AE2, and AE3.

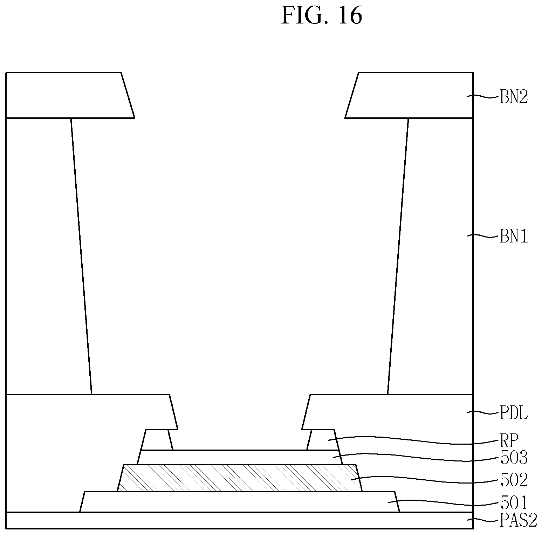

Next, referring to FIG. 16, the method may include performing a sixth etching process which etches the sacrificial layers SFL, exposing the pixel electrodes AE1, AE2, and AE3. The sacrificial layers SFL are removed in exposed areas, but may remain as partial residual patterns RP between the upper transparent electrode layers 503 of the pixel electrodes AE1, AE2, and AE3 and the inorganic pixel defining layer PDL. As portions exposed after the sacrificial layers SFL are removed, spaces may be formed between the pixel electrodes AE1, AE2, and AE3 and the inorganic pixel defining layer PDL disposed above the pixel electrodes AE1, AE2, and AE3. In a subsequent process, the method may include forming the light emitting layers EL1, EL2, and EL3 disposed on the pixel electrodes AE1, AE2, and AE3, respectively, to fill the spaces.

Subsequently, although not illustrated in the drawings, the method may include forming the light emitting elements ED1, ED2, and the ED2 by forming the light emitting layers EL1, EL2, and EL3 and the common electrodes CE1, CE2, and CE3 on the pixel electrodes AE1, AE2, and AE3, respectively. Subsequently, the method may include fabricating the display device 10 by forming the thin film encapsulation layer TFEL, the color filter layer CFL, and the overcoat layer OC on the light emitting elements ED1, ED2, and ED3 and the bank structure BNS. Structures of the light emitting layer EL1, EL2, and EL3, the common electrode CE1, CE2, and CE3, the thin film encapsulation layer TFEL, the color filter layer CFL, and the overcoat layer OC are the same as those described herein, and a detailed description thereof is thus omitted.

The display device according to one embodiment of the present disclosure can be applied to various electronic devices. The electronic device according to the one embodiment of the present disclosure includes the display device described above, and may further include modules or devices having additional functions in addition to the display device.

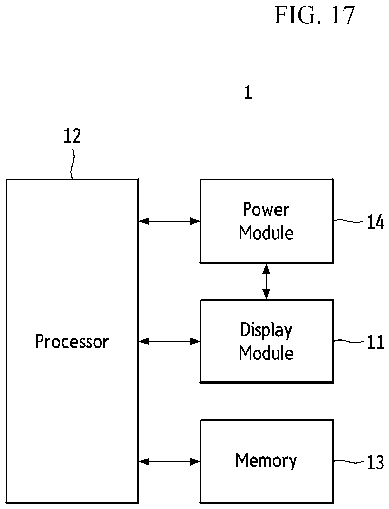

FIG. 17 is a block diagram of an electronic device according to one embodiment of the present disclosure.

Referring to FIG. 17, the electronic device 1 according to one embodiment of the present disclosure may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, an image data signal and/or an input control signal is transmitted to the display module 11, and the display module 11 can process the received signal and output image information through a display screen.

The power module 14 may include a power supply module such as, for example a power adapter or a battery, and a power conversion module that converts the power supplied by the power supply module to generate power necessary for the operation of the electronic device 1.

At least one of the components of the electronic device 11 according to the one embodiment of the present disclosure may be included in the display device 10 according to the embodiments of the present disclosure. In addition, some modules of the individual modules functionally included in one module may be included in the display device 10, and other modules may be provided separately from the display device 10. For example, the display device 10 may include the display module 11, and the processor 12, the memory 13, and the power module 14 may be provided in the form of other devices within the electronic device 11 other than the display device 10.

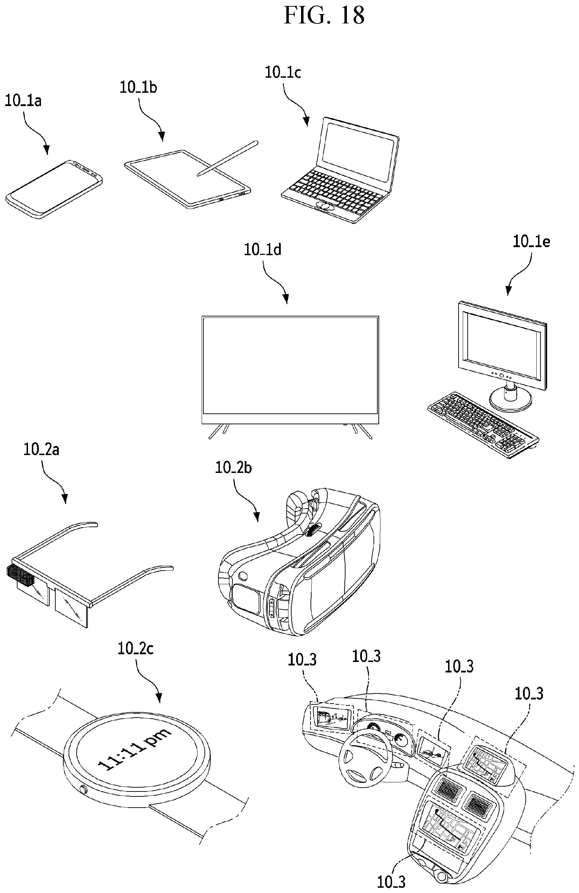

FIG. 18 is a schematic diagram of an electronic device according to various embodiments of the present disclosure.

Referring to FIG. 18, various electronic devices to which display devices 10 according to embodiments of the present disclosure are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

The embodiments of the present disclosure have been described hereinabove with reference to the accompanying drawings, but it will be understood by one of ordinary skill in the art to which the present disclosure pertains that various modifications and alterations may be made without departing from the technical idea of the present disclosure. Therefore, it is to be understood that the embodiments described herein are illustrative examples rather than being restrictive in all aspects.

The invention should not be construed as being limited to the embodiments set forth herein. Rather, the example embodiments are provided so that this disclosure will be thorough and complete and will fully convey the concept of the invention to those skilled in the art.

While the invention has been particularly illustrated and described with reference to embodiments thereof, it will be understood by those of ordinary skill in the art that various changes in form and details may be made therein without departing from the scope of the invention as defined by the following claims.

## Claims

1. A display device comprising:
a pixel electrode comprising a lower transparent electrode layer disposed on a substrate, a metal electrode layer disposed on the lower transparent electrode layer, and an upper transparent electrode layer disposed on the metal electrode layer;
an inorganic pixel defining layer disposed on the substrate and exposing the pixel electrode;
a light emitting layer disposed on the pixel electrode;
a common electrode disposed on the light emitting layer;
a first bank disposed on the inorganic pixel defining layer; and
a second bank disposed on the first bank and having a side surface protruding more than a side surface of the first bank,
wherein a side surface of the lower transparent electrode layer is aligned with a side surface of the metal electrode layer or protrudes more than the side surface of the metal electrode layer.

2. The display device of claim 1, wherein the side surface of the metal electrode layer protrudes more than a side surface of the upper transparent electrode layer, optionally wherein at least a portion of an upper surface of the metal electrode layer, an edge of the metal electrode layer, or the side surface of the metal electrode layer is exposed and is not covered by the upper transparent electrode layer.

3. The display device of claim 1 or claim 2, wherein at least a portion of an upper surface of the lower transparent electrode layer, an edge of the lower transparent electrode layer, or the side surface of the lower transparent electrode layer is exposed and is not covered by the metal electrode layer.

4. The display device of any one of claims 1 to 3, wherein the lower transparent electrode layer and the upper transparent electrode layer respectively comprise different transparent conductive oxides (TCO).

5. The display device of claim 4, wherein:
the lower transparent electrode layer comprises zinc indium tin oxide (ZITO), and
the upper transparent electrode layer comprises indium tin oxide (ITO).

6. The display device of claim 5, wherein:
(i) the lower transparent electrode layer is amorphous; and/or
(ii) a ratio of zinc (Zn) to a total number of metal atoms comprised in the lower transparent electrode layer is 25 at% to 45 at%, and
a ratio of tin (Sn) to a total number of metal atoms comprised in the lower transparent electrode layer is 15 at% to 35 at%.

7. The display device of any one of claims 1 to 6, wherein:
(i) a thickness of the lower transparent electrode layer is greater than a thickness of the upper transparent electrode layer; and/or
(ii) a thickness of the metal electrode layer is greater than each of a thickness of the lower transparent electrode layer and a thickness of the upper transparent electrode layer; and/or
(iii) a thickness of the lower transparent electrode layer is 1 nm to 25 nm.

8. The display device of any one of claims 1 to 7, further comprising a residual pattern disposed between the upper transparent electrode layer and the inorganic pixel defining layer.

9. The display device of claim 8, wherein the residual pattern comprises a first side aligned with a side surface of the upper transparent electrode layer.

10. The display device of claim 9, wherein the inorganic pixel defining layer comprises:
a first side surface adjacent to the first bank;
a first lower surface connected to the first side surface and facing an upper surface of the residual pattern;
a second side surface connected to the first lower surface and facing the first side surface of the residual pattern and the side surface of the upper transparent electrode layer;
a second lower surface connected to the second side surface and facing an upper surface of the metal electrode layer; and
a third side surface connected to the second lower surface and facing the side surface of the metal electrode layer,
wherein:
the first side surface of the inorganic pixel defining layer protrudes more than the second side surface of the inorganic pixel defining layer, and
the second side surface of the inorganic pixel defining layer protrudes more than the third side surface of the inorganic pixel defining layer.

11. The display device of claim 10, wherein:
(i) the residual pattern comprises a second side surface opposite to the first side surface, and
the second side surface of the residual pattern is aligned with the first side surface of the inorganic pixel defining layer or is positioned between the first side surface of the inorganic pixel defining layer and the second side surface of the inorganic pixel defining layer; and/or
(ii) the inorganic pixel defining layer further comprises:
a third lower surface connected to the third side surface and facing an upper surface of the lower transparent electrode layer; and
a fourth side surface connected to the third lower surface and facing the side surface of the lower transparent electrode layer.

12. The display device of any one of claims 1 to 11, wherein one end of the common electrode and another end of the common electrode are in contact with the first bank.

13. A method of fabricating a display device, the method comprising:
forming a lower transparent electrode material layer on a substrate, forming a metal electrode material layer on the lower transparent electrode material layer, forming an upper transparent electrode material layer on the metal electrode material layer, and forming a sacrificial layer on the upper transparent electrode material layer;
performing a first etching process comprising etching the sacrificial layer, the upper transparent electrode material layer, and the metal electrode material layer; and
performing a second etching process comprising etching the lower transparent electrode material layer,
wherein the first etching process and the second etching process respectively use different etchants.

14. The method of claim 13, wherein:
(i) the performing of the second etching process comprising the etching of the lower transparent electrode material layer comprises controlling the second etching process such that a side surface of the lower transparent electrode material layer is aligned with a side surface of the metal electrode material layer or protrudes more than the side surface of the metal electrode material layer; and/or
(ii) the first etching process uses a fluorine-based etchant, and
the second etching process uses a phosphoric acid-based, nitric acid-based, or acetic acid-based etchant.

15. An electronic device comprising a display device according to any one of claims 1 to 12.
